(19) Europäisches Patentamt
European Patent Office
Office européen des brevets

(11) EP 1 309 010 A2

(12) EUROPEAN PATENT APPLICATION

(43) Date of publication:
**07.05.2003 Bulletin 2003/19**

(51) Int Cl.[7]: **H01L 29/06**, H01L 33/00, H01L 27/15

(21) Application number: **02024443.0**

(22) Date of filing: **29.10.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: **30.10.2001 JP 2001333129**

(71) Applicant: **SUMITOMO CHEMICAL COMPANY, LIMITED**
**Chuo-ku, Osaka (JP)**

(72) Inventors:
- **Ono, Yoshinobu**
**Tsukuba-gun, Ibaraki (JP)**
- **Hata, Masahiko**
**Tsuchiura-shi, Ibaraki (JP)**
- **Sazawa, Hiroyuki**
**Tsukuba-shi, Ibaraki (JP)**

(74) Representative: **VOSSIUS & PARTNER**
**Siebertstrasse 4**
**81675 München (DE)**

# (54) 3-5 group compound semiconductor and semiconductor device

(57) A 3-5 group compound semiconductor comprising a conductive substrate and a device layer of a 3-5 group compound semiconductor formed by epitaxial growth on said conductive substrate, which comprises between said conductive substrate and said device layer a pn laminate structure layer having at least one pn junction comprising a p-type layer having p-type conductivity and an n-type layer having n-type conductivity.

FIG.1

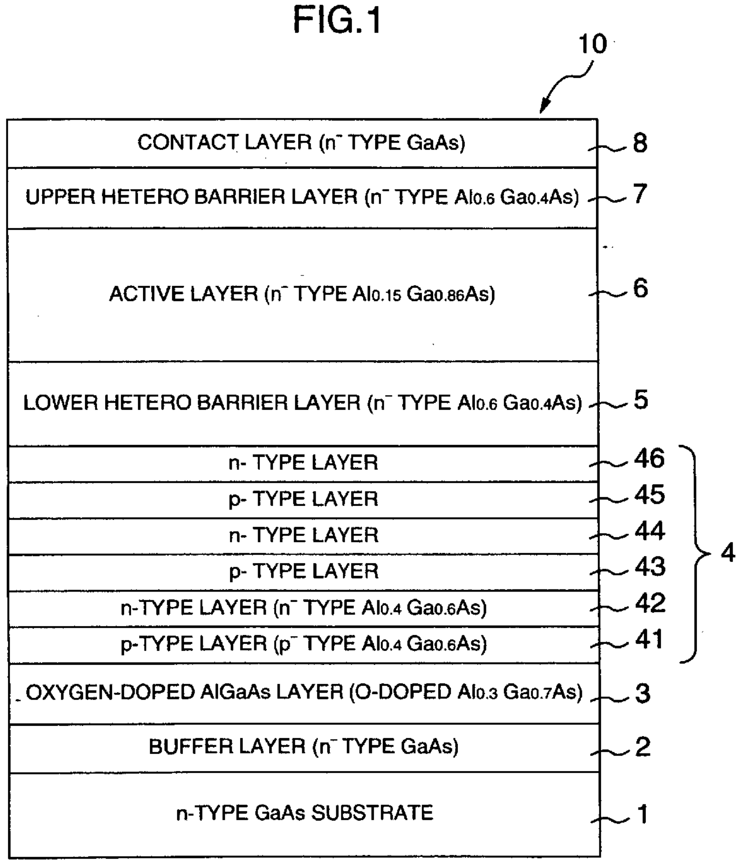


EP 1 309 010 A2

## Description

This invention relates to a 3-5 group compound semiconductor and a semiconductor device. In more particular, it relates to a 3-5 group compound semiconductor which has a layer structure of epitaxial growth crystals suitable for constituting an element array having a pn junction, and to a semiconductor device.

In recent years, in the field of various high speed electronic elements or optical elements which contain a semiconductor pn junction layer, much efforts has been made to develop a high density integrated element array comprising a single semiconductor substrate and a large number of elements monolithically mounted thereon. However, when it is intended to integrate various elements in high density on a single substrate, particularly on a conductive substrate, there arise problems of increase of leak current between integrated elements and increase of interference of elements with each other.

As the means for suppressing the inter-element leak current which causes such interference, there have been proposed, for example, a method wherein the respective elements are formed on a semi-insulating substrate, and element-separating grooves having a depth which reaches the semi-insulating substrate are formed to attain electric insulation between respective elements, and a method wherein a semi-insulating epitaxial layer is formed on a conductive substrate, then a device layer is formed on the semi-insulating epitaxial layer, and element-separating grooves having a depth which reaches the semi-insulating epitaxial layer are formed to attain electric insulation between respective elements.

Of the two methods described above, particularly the latter method is advantageous from the viewpoint of design because it has a high degree of freedom with regard to the conduction type of the substrate. Furthermore, for enhancing the reliability of such an element array as a pn junction diode, a bypolar transistor containing an npn junction or a thyristor containing a pnpn junction, the use of a substrate of low dislocation density having a high crystallinity is particularly effective. In many cases, conductivity is imparted by impurity elements added for obtaining the low dislocation density. Accordingly, the latter method, wherein a conductive substrate is used and a semi-insulating epitaxial layer is provided for separating elements, is more promising.

Similarly, the problem of interference between respective semiconductor elements arises also in the case of other semiconductor devices prepared by integrating various semiconductor elements in high density. The problem of preventing inter-element interference becomes more important as the element density becomes higher and the inter-element distance becomes smaller.

When a semi-insulating epitaxial layer used for insulation between elements is formed on a substrate, a so-called undoped epitaxial layer grown without supply of a dopant source has been heretofore used. However, even when an undoped epitaxial layer is formed for such a purpose, it is not easy thereby to form a layer having a practically sufficient electric insulating property and in many cases the leak current between semiconductor elements cannot be suppressed sufficiently. As a result, in preparing for example a pn junction diode array, npn bipolar transistor array or pnpn thyristor array, even when an undoped epitaxial layer is formed on a conductive substrate to suppress an inter-element leak current, a satisfactory result cannot always be obtained, and it is not easy to make respective diodes operate under sufficiently independent conditions.

An object of this invention is to provide a 3-5 group compound semiconductor, semiconductor device and element array wherein the development of leak currents between elements, which causes a problem when various semiconductor elements are formed in high density on a substrate, can be effectively suppressed.

Another object of this invention is to provide a 3-5 group compound semiconductor, semiconductor device and element array which make it possible to prepare an array wherein the development of inter-element leak currents is sufficiently suppressed and elements are integrated in high density.

To solve the above-mentioned problems, according to this invention, there is provided a 3-5 group compound semiconductor comprising a conductive substrate and a device layer of a compound semiconductor formed by epitaxial growth on said conductive substrate, which is of a structure comprising, as an insulating layer, a pn laminate structure layer having a pn junction composed of a p-type conductive layer and an n-type conductive layer provided between the substrate and the device layer. The semiconductor may also be of a structure which comprises, in place of the pn laminate structure layer or in addition thereto, an oxygen-doped AlGaAs layer provided as a high resistant layer.

According to this invention, further, there is provided a semiconductor element array comprising a conductive substrate and a double hetero type device layer containing a pn junction composed of a 3-5 group compound semiconductor formed on said conductive substrate, which is of a structure wherein the conduction type of a hetero barrier layer provided between said device layer and said conductive substrate is made to be the same as the conduction type of that part of an active layer adjacent to said hetero barrier layer and containing the pn junction interface, which part is in contact with said hetero barrier layer, whereby band discontinuity caused by composition difference is developed in the valence band thereby to suppress the current which flows between the device layer and the conductive substrate.

According to the aspect of claim 1 of this invention, there is provided a 3-5 group compound semiconductor comprising a conductive substrate and a device layer of a 3-5 group compound semiconductor formed by epitaxial growth on said conductive substrate, which comprises between said conductive substrate and said device layer a pn laminate structure layer having at least one pn junction comprising a p-type layer having p-type conductivity and an n-type layer having n-type conductivity.

By forming at least one pn junction layer by lamination of a p-type layer and an n-type layer, an electric current which will tend to flow through the pn lamination structure layer in perpendicular direction can be suppressed by an energy barrier formed by said at least one pn junction, the necessary electric insulating condition between the conductive substrate and the device layer can be secured, and leakage can be reduced. Though the laminate structure comprising a p-type layer and an n-type layer is effective when at least one pair thereof is provided, when a repeated lamination structure of two or more pairs is adopted, the current which flows in a direction perpendicular to the pn laminate structure layer can be suppressed more effectively.

According to the aspect of claim 2 of this invention, there is provided a 3-5 group compound semiconductor comprising a conductive substrate and a device layer of a 3-5 group compound semiconductor formed by epitaxial growth on said conductive substrate, which comprises an oxygen-doped AlGaAs layer provided between said conductive substrate and said device layer.

The oxygen-doped AlGaAs layer constitutes a high resistance layer. The resistance thereof in the film thickness direction is determined by Al composition, oxygen-doping concentration and thickness of the layer formed. By providing an oxygen-doped AlGaAs layer which shows high resistance in the film thickness direction, an electric current which will tend to flow in its thickness direction can be suppressed, an electric current which will flow between the device layer and the conductive substrate can be effectively suppressed, and the problem of leak current can be solved. Thus, by providing an oxygen-doped AlGaAs layer, the necessary electric insulating condition between the conductive substrate and the device layer can be secured, and the leak current can be reduced.

According to the aspect of claim 3 of this invention, there is provided a 3-5 group compound semiconductor according to claim 1 which further comprises an oxygen-doped AlGaAs layer between said conductive substrate and said device layer.

According to the aspect of claim 4 of this invention, there is provided a 3-5 group compound semiconductor according to claim 3 wherein said oxygen-doped AlGaAs layer is provided between said conductive substrate and said pn laminate structure layer.

According to the aspect of claim 5 of this invention, there is provided a semiconductor device which comprises the 3-5 group compound semiconductor according to claim 1, 2, 3 or 4.

According to the aspect of claim 6 of this invention, there is provided an element array comprising a conductive substrate and a device layer of a 3-5 group compound semiconductor formed by epitaxial growth on said conductive substrate, said device layer being a double hetero type device layer comprising a pair of hetero barrier layers and an active layer held between said hetero barrier layers, wherein the conduction type of that hetero barrier layer which, of said pair of hetero barrier layers, is provided on the conductive substrate side (hereinafter referred to as the lower hetero barrier layer) is the same as that of said active layer.

Thus, by making the conduction type of the lower hetero barrier layer the same as that of the active layer adjacent thereto, band discontinuity is caused by composition difference in the valence band, resultantly the electric current which flows between the active layer and the conductive substrate can be suppressed by the energy barrier thus formed, and inter-element interference can be reduced.

According to the aspect of claim 7 of this invention, there is provided an element array according to claim 6 which comprises a pn laminate structure layer having at least one pn junction comprising a p-type layer having p-type conductivity and an n-type layer having n-type conductivity between said hetero barrier layer and said conductive substrate.

According to the aspect of claim 8 of this invention, there is provided an element array according to claim 6 which further comprises an oxygen-doped AlGaAs layer between said lower hetero barrier layer and said conductive substrate.

According to the aspect of claim 9 of this invention, there is provided an element array according to claim 7 which further comprises an oxygen-doped AlGaAs layer between said lower hetero barrier layer and said conductive substrate.

According to the aspect of claim 10 of this invention, there is provided an element array according to claim 9 wherein said oxygen-doped AlGaAs layer is provided between said conductive substrate and said pn laminate structure layer.

According to this invention, the development of inter-element interference due to leak currents between elements which poses a serious problem when various semiconductor elements are formed in high density on a substrate can be effectively suppressed by adding a simple step of repeatedly laminating a p-type layer and an n-type layer or by forming an oxygen-doped AlGaAs layer. Since the oxygen-doped AlGaAs layer can grow high resistance crystals more stably as compared with an undoped epitaxial layer, it can provide an element having high reliability.

In the use of a double hetero junction type pn-junction diode element, in place of that described above or in addition thereto, by providing one of a pair of hetero barrier layers on the side of the substrate, said one hetero barrier layer having the same conduction type as that of the active layer, band discontinuity in the valence band is caused by the difference of Al contents between the active layer and hetero barrier layer, and thereby current leakage can be suppressed, and inter-element interference can be reduced. Accordingly, merely by adding some change to the previous process step, it becomes possible to prepare a diode element array in which the development of inter-element interference can be sufficiently suppressed and which exhibits stable diode characteristics.

Fig. 1 is a sectional view showing one example of the embodiment of the 3-5 group compound semiconductor according to this invention.

Fig. 2 is a sectional view showing one example of a pn junction diode array constructed by using the 3-5 group compound semiconductor shown in Fig. 1.

One example of the embodiment of this invention is described in detail below with reference to Figures.

Fig. 1 is a sectional view showing one example of the embodiment of the 3-5 group compound semiconductor according to this invention. The 3-5 group compound semiconductor 10 is used for preparing a double hetero type pn junction diode array, and is of a layer structure comprising a conductive n-type GaAs substrate 1 and a plurality of compound semiconductor thin film crystal layers containing an active layer formed on the substrate 1 by successive lamination using metal organic vapor phase epitaxy (MOVPE).

In this Embodiment, a buffer layer 2 is laminated as an $n^-$ type GaAs layer on the n-type GaAs substrate 1. Then, on the buffer layer 2 are laminated an oxygen-doped AlGaAs layer 3, which is an 0-doped $Al_{0.3}Ga_{0.7}As$ layer and works as a high resistance layer, and further a pn laminate structure layer 4 for use in suppressing electric currents by an energy barrier caused by pn junction.

On the pn laminate structure layer 4 is further formed a double hetero type device layer of 3-5 group compound semiconductor of the so-called double hetero structure which comprises an active layer 6 comprising an $n^-$ type $Al_{0.15}Ga_{0.85}As$ layer held between a lower hetero barrier layer 5 and an upper hetero barrier layer 7 each having a larger energy gap than the active layer 6. In the present Embodiment, the lower hetero barrier layer 5 and the upper hetero barrier layer 7 each comprises an $n^-$ type $Al_{0.6}Ga_{0.4}As$ layer, and a contact layer 8 comprising an $n^-$ type GaAs layer is further formed on the upper hetero barrier layer 7.

The pn laminate structure layer 4 comprises p-type layers 41, 43 and 45 each comprising a $p^-$ type $Al_{0.4}Ga_{0.6}As$ layer having p-type conductivity and n-type layers 42, 44 and 46 each comprising an $n^-$ type $Al_{0.4}Ga_{0.6}As$ layer having n-type conductivity, which are laminated as shown in Figure 1. Thus, the pn laminate structure layer 4 has a repeated laminate structure wherein p-type layers and n-type layers are alternately laminated, whereby a pn junction is formed between a p-type layer and an n-type layer adjacent thereto.

In the present Embodiment, the pn laminate structure layer 4 has a 6-layer structure wherein the number of repeated lamination of p-type layers and n-type layers is 6; it contains 3 pairs of a p-type layer and an n-type layer, and the number of pn junctions is 5.

As described above, the pn laminate structure layer 4 comprising repeated pn junctions is provided as an electric insulating layer for preventing leak currents from flowing from the active layer 6, the device active layer, to the n-type GaAs substrate 1 by utilizing the energy barrier formed by pn junctions. Thus, by the action of the energy barrier formed in the pn laminate structure layer 4 comprising repeated pn junctions, electrons and holes which flow in a direction perpendicular to the respective layers of the 3-5 group compound semiconductor 10 are blocked by the pn laminate structure layer 4.

Therefore, by using the 3-5 group compound semiconductor 10 constructed as mentioned above, as described below in detail, the electric current comes to flow only through its proper path and the development of a leak current can be suppressed.

In general, the energy barrier of a pn junction can be made larger as the energy gap of the material used is larger; hence, when the above-mentioned layer structure is constructed for example, with AlGaAs type materials, a larger Al content is preferable within limits not deleterious to the crystal quality.

The thickness of each of p-type layers 41, 43 and 45 and n-type layers 42, 44 and 46 is preferably about the same as or larger than the thickness of the depletion layer of the pn junction depending on carrier concentration. When the thickness is smaller than that described above, in some cases a sufficient effect cannot be obtained in preventing an electric current from flowing to the leak path. Since the depletion layer thickness is inversely proportional to the square root of carrier concentration, the thickness of each layer can be made smaller as the carrier concentration of the pn junction formed is higher. Herein, the conductivities of the p-type layers and the n-type layers constituting the pn laminate structure layer 4 should be specified by substantial carrier concentration; for example, even in layers grown without supply of a dopant (so-called undoped layers), those which show p-type or n-type conductivity should be regarded as a p-type layer or n-type layer.

Since an advantageous effect can be obtained even when the number of repeated pn junction is 1, the pn laminate structure layer 4 suffices so long as it has at least one p-type layer and at least n-type layer; but when the lamination repetition number is increased, the leak current prevention effect becomes larger. In particular, when thin layers are used in a pn junction having a high carrier concentration, a leak current tends to develop owing to tunnel effect, since the barrier thickness becomes small. In such a case, the larger the lamination repetition number, the larger the leak current suppression effect.

In the present Embodiment, in addition to suppression of leak current by use of the pn laminate structure layer 4, further, a high resistance layer is provided by forming an oxygen-doped AlGaAs layer 3, thereby to suppress a leak current.

Thus, the high resistance layer provided by the oxygen-doped AlGaAs layer 3 utilizes an oxygen-doped AlGaAs layer, which is known to have high resistance, to prevent a leak current from flowing to the n-type GaAs substrate 1. The oxygen-doped AlGaAs layer 3 has an advantage in that it can grow high resistance crystals more stably as compared with undoped epitaxial layers.

The resistivity of the oxygen-doped AlGaAs layer 3 in the film thickness direction is determined by Al content, oxygen dope concentration and layer thickness. The Al content is preferably high within a range not harmful to crystal quality, and is preferably about 0.3-0.5 in practice. The oxygen dope concentration also is preferably high within a range not harmful to crystal quality, and is preferably about $7 \times 10^{15}$ - $1 \times 10^{19}$ $cm^{-3}$. The thickness of the oxygen-doped AlGaAs layer 3 is preferably large within a range not harmful to the growth time.

In the present Embodiment, further, the semiconductor 10 is also of a structure wherein the leak current which flows to the n-type GaAs substrate 1 can be surpressed by controlling the conduction type of the lower hetero barrier layer 5. In general, when it is intended to construct a pn junction diode array with AlGaAs type crystals, the lower hetero barrier layer 5 is formed as an undoped layer so as to have an insulating function, too, and the active layer 6 and the upper hetero barrier layer 7 provided on the upper part thereof are formed as an n-type layer. By adding a p-type impurity to a part of the n-type active layer 6 and of the upper hetero barrier layer 7 by means of ion implantation or thermal diffusion, or by forming a p-type semiconductor layer by means of selective epitaxial growth, a pn junction element can be formed. However, a lower side hetero barrier layer obtained by using undoped AlGaAs having a high Al content is apt to be a layer which shows low concentration p-type conductivity, and moreover a p-type carrier concentration can be hardly stabilized. As a result, an energy barrier against holes is difficultly formed in the valence band between the active layer 6 and the lower hetero barrier layer 5, and holes may possibly leak to the side of the n-type GaAs substrate 1. To avoid such a problem, the semiconductor 10 is of a structure wherein the conduction type of the lower hetero barrier layer 5 is made to be the same as the conduction type (n-type) of the active layer 6 adjacent to the layer 5, whereby band discontinuity due to composition difference is developed in the valence band and thereby the leak of holes to the downward of the n-type GaAs substrate 1 can be suppressed.

In the Embodiment shown in Fig. 1, the semiconductor 10 is of a structure which is provided with three layers described in detail above for suppressing the leak of current between the device layer containing pn junctions and the n-type GaAs substrate 1. Specifically, the semiconductor 10 has the pn laminate structure layer 4, the oxygen-doped AlGaAs layer 3 and the lower hetero barrier layer 5 having the same conduction type as that of the part, adjacent to the lower hetero barrier layer, of the active layer 6 held between hetero barrier layers. However, each of these layers is capable of suppressing a leak current sufficiently even when used each alone, and it is not necessarily required to use all of the three layers. However, as compared with a case wherein any one of the three layers is used alone, the use of any two layers or all of the three layers as shown in the present embodiment makes it possible to suppress the development of a leak current more effectively.

Though the embodiment shown in Fig. 1 shows an example of a 3-5 group compound semiconductor having a layer structure used for preparing a pn junction diode element array, this invention is not limited to a 3-5 group compound semiconductor used only for preparing a pn junction diode element array, and can be similarly applied for suppressing a leak current (inter-element interference) in other elements; for example, hetero bipolar transistors having an npn junction and a ppn junction or thyristors having a pnpn junction.

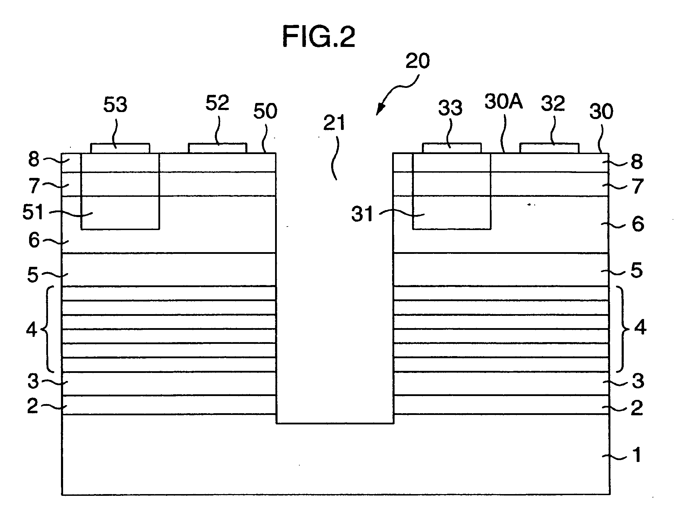

Fig. 2 shows a sectional view of one example of a pn junction diode array which is a semiconductor device constructed by using the 3-5 group compound semiconductor 10 shown in Fig. 1. Since the layer structure of the pn junction diode array 20 shown in Fig. 2 is exactly the same as that shown in Fig. 1, among the respective parts in Fig. 2, those which correspond to the parts of Fig. 1 are indicated by the same reference numerals, respectively.

The pn junction diode array 20 comprises two pn junction diodes 30 and 50 made up by forming an element separation groove 21 to the depth which reaches an n-type GaAs substrate 1. On the upper surface 30A of the pn junction diode are respectively formed an n electrode 32 on a contact layer 8 which is an n-type region and a p electrode 33 on a p-type region 31 formed at the upper part of the pn junction diode 30. By application of voltage to the n electrode 32 and the p electrode 33 provided on the same face of the pn junction diode 30, a rectification characteristic based on the pn junction is obtained. Similarly, the pn junction diode 50 is provided with an n electrode 52 on the contact layer 8 and a p electrode 53 on a p-type region 51.

Since the pn junction diode array 20 is constructed as described above, when, for example, the pn junction diode 30 alone is driven, the leak current which will tend to flow from the pn junction diode 30 to the pn junction diode 50 is suppressed by a lower hetero barrier layer 5, a pn laminate structure layer 4 and an oxygen-doped AlGaAs layer 3, so that even when the n-type GaAs substrate 1 is conductive, the leak current can be substantially prevented from flowing to the pn junction diode 50 via the n-type GaAs substrate 1. Accordingly, in a pn junction diode array having a structure such as the pn junction diode array 20, the development of interfering effect on current-voltage characteristics due to leak currents between respective pn junction diodes can be effectively suppressed. The same applies when the pn junction diode 50 alone is driven. Furthermore, when the pn junction diodes 30 and 50 are driven at the same time, interference between the two diodes can be effectively suppressed.

This invention is further described in detail below with reference to the following Examples.

Though the Examples shown below are those regarding the layer structure of an AlGaAs type 3-5 group compound semiconductor on a GaAs substrate, this invention is not necessarily limited to this type. For example, the invention can be similarly applied to an AlInGaP type 3-5 group compound semiconductor on a GaAs substrate, InGaAsP type 3-5 group compound semiconductor on an InP substrate and InGaN type 3-5 group compound semiconductor on a GaN substrate. Further, though the Examples describe only examples of pn junction diode elements, as regards a structure provided with an oxygen-doped AlGaAs layer 3 and a pn laminate structure layer 4, the application of this invention is not necessarily limited to pn junction diode elements. The invention can be applied similarly to various light emitting elements, photo-detectors, electronic elements, etc. which are capable of bipolar operation and contain a ppn junction, an npn junction and a pnpn junction and also to elements arranged in the form of array and elements arranged two-dimensionally.

The Examples shown below all relates to a pn junction diode array having the structure shown in Fig. 2.

Example 1

The pn laminate structure 4 was constructed with a repetition number of 6 and with a p-type layer ($p^-$ type $Al_{0.4}Ga_{0.6}As$) having a carrier concentration of 2 x $10^{18}$ $cm^{-3}$ and a layer thickness of 40 nm and an n-type layer ($n^-$ type $Al_{0.4}Ga_{0.6}As$) having a carrier concentration of 2 x $10^{18}$ $cm^{-3}$ and a layer thickness of 40 nm.

The oxygen-doped AlGaAs layer (oxygen-doped $Al_{0.3}Ga_{0.7}As$) 3 had an oxygen concentration of 5 x $10^{18}$ $cm^{-3}$ and a layer thickness of 220 nm.

The conduction type of the lower hetero barrier layer 5 was n-type.

The above-mentioned structure is described in detail below. On an n-type GaAs substrate was grown an epitaxial layer having the layer structure shown in Fig. 2. Thus, on an $n^-$ type GaAs buffer layer were grown 220 nm of an oxygen-doped $Al_{0.3}Ga_{0.7}As$ layer having an oxygen concentration of 5 x $10^{18}$ $cm^{-3}$ and succeedingly 6 cycles of pn laminate structure layers comprising $Al_{0.4}Ga_{0.6}As$. The p-type layer and the n-type layer each had a concentration of 2 x $10^{18}$ $cm^{-3}$ and a layer thickness of 40 nm. Successively a double hetero structure was grown, which comprised an $n^-$ type $Al_{0.6}Ga_{0.4}As$ lower hetero barrier layer, an $n^-$ type $Al_{0.15}Ga_{0.85}As$ active layer and an n- type $Al_{0.6}Ga_{0.4}As$ upper hetero barrier layer. Successively, further, an $n^-$ type GaAs contact layer was grown.

Onto the epitaxial crystals thus prepared was injected Zn by means of selective ion implantation, and an activating heat treatment was applied thereto to form a p-type region having a depth which reached midway of the active layer and thereby to form a pn junction diode. Then, to effect element separation between blocks, a separating groove which reached the substrate was formed by photolithography. Then, a p-type ohmic electrode was formed on the p-type region and an n-type ohmic electrode on the n-type region.

The pn junction diode array thus prepared was used for measurement of leak current between diodes by the following method. While a constant current of 5 mA was being passed to the p electrode of one side pn junction diode, a current was swept from 0 to 20 mA at the p electrode of the other side pn junction diode. During the sweeping, the currents which flow through the n electrode adjacent to the one side pn junction diode and through the n electrode adjacent to the other side pn junction diode were measured, respectively. From the value I of the current which flows through the -n electrode adjacent to the one side pn junction diode when the sweep current is 20 mA, the degree A of inter-element interference was calculated by the following equation.

$$A\ (\%) = (I - I_0)/I_0 \times 100$$

$$I_0 = 5\ mA$$

The smaller the degree A of interference between pn diode elements, the more desirable.

The average of the degree of inter-element interference obtained in this Example was 0.4%.

Example 2

A pn junction diode array was prepared according to the same method as in Example 1 except that the layer structure of epitaxial crystals differed in the following points, and the inter-element interference effect due to the leak current between diodes was evaluated according to the same method.

Thus, the pn laminate structure layer 4 was constructed with a repetion number of 24 and with an n-type layer ($n^-$ type $Al_{0.4}Ga_{0.6}As$) having a carrier concentration of 2 x $10^{18}$ $cm^{-3}$ and a layer thickness of 10 nm and a p-type layer ($p^-$ type $Al_{0.4}Ga_{0.6}As$) being undoped and having a layer thickness of 10 nm.

The oxygen-doped AlGaAs layer 3 was prepared under the same conditions as in Example 1.
The conduction type of the lower hetero barrier layer 5 was also the same as in Example 1.
Measurement showed that the degree of inter-element interference was 0.7%.

Example 3

A pn junction diode array was prepared according to the same method as in Example 1 except that the layer structure of epitaxial crystals was different in the following points, and evaluated according to the same method.
That is, the pn laminate structure layer 4 was absent.
The oxygen-doped AlGaAs layer 3 was prepared under the same conditions as in Example 1 except that the layer thickness was 300 nm.
The conduction type of the lower hetero barrier layer 5 was also the same as in Example 1.
Measurement showed that the degree of inter-element interference was 2.5%.

Example 4

A pn junction diode array was prepared according to the same method as in Example 1 except that the layer structure of epitaxial crystals was different in the following points, and evaluated according to the same method.
That is, the pn laminate structure layer 4 was constructed with a repetition number of 24 and with an n-type layer (n- type GaAs) having a carrier concentration of 2 x $10^{18}$ $cm^{-3}$ and a layer thickness of 10 nm and a p-type layer ($p^-$ type $Al_{0.4}Ga_{0.6}As$) being undoped and having a layer thickness of 10 nm.
The oxygen-doped AlGaAs layer 3 was not formed.
The conduction type of the lower hetero barrier layer 5 was the undoped type (p-type).
Measurement showed that the degree of inter-element interference was 10.3%.

Example 5

A pn junction diode array was prepared according to the same method as in Example 1 except that the layer structure of epitaxial crystals was different in the following points, and evaluated according to the same method.
That is, the pn laminate structure layer 4 was constructed with a repetition number of 10 and with an n-type layer ($n^-$ type GaAs) having a carrier concentration of 2 x $10^{18}$ $cm^{-3}$ and a layer thickness of 10 nm and a p-type layer ($p^-$ type $Al_{0.4}Ga_{0.6}As$) being undoped and having a layer thickness of 10 nm.
The oxygen-doped AlGaAs layer 3 was prepared under the same conditions as in Example 1 except that the layer thickness was 280 nm.
The conduction type of the lower hetero barrier layer 5 was the undoped type (p-type).
Measurement showed that the degree of inter-element interference was 11.7%.

Comparative Example

A pn junction diode array was prepared according to the same method as in Example 1 except that the layer structure of epitaxial crystals was different in the following points, and evaluated according to the same method.
That is, neither the pn laminate structure layer 4 nor the oxygen-doped AlGaAs layer 3 was formed.
The conduction type of the lower hetero barrier layer 5 was the undoped type (p-type).
Measurement showed that the degree of inter-element interference was 19%.
From the respective results of measurement in Examples 1-5 and Comparative Example, it is apparent that

(1) merely by adopting any one of the barriers based on the pn laminate structure layer 4, an oxygen-doped AlGaAs layer 3 or a lower hetero barrier layer, inter-element interference can be markedly improved than previously, and
(2) though an effect of inter-element interference suppression can be sufficiently obtained even when the repetition number of the pn laminate structure layer 4 was one, a more enhanced effect can be obtained when the repetition number is increased.

**Claims**

1. A 3-5 group compound semiconductor comprising a conductive substrate and a device layer of a 3-5 group compound semiconductor formed by epitaxial growth on said conductive substrate, which comprises between said conductive substrate and said device layer a pn laminate structure layer having at least one pn junction comprising a p-type layer having p-type conductivity and an n-type layer having n-type conductivity.

2. A 3-5 group compound semiconductor comprising a conductive substrate and a device layer of a 3-5 group compound semiconductor formed by epitaxial growth on said conductive substrate, which comprises an oxygen-doped AlGaAs layer between said conductive substrate and said device layer.

3. The 3-5 group compound semiconductor according to claim 1 which further comprises an oxygen-doped AlGaAs layer between said conductive substrate and said device layer.

**4.** The 3-5 group compound semiconductor according to claim 3 wherein said oxygen-doped AlGaAs layer is provided between said conductive substrate and said pn laminate structure layer.

**5.** A semiconductor device which comprises the 3-5 group compound semiconductor according to claim 1, 2, 3 or 4.

**6.** An element array comprising a conductive substrate and a device layer of a 3-5 group compound semiconductor formed by epitaxial growth on said conductive substrate, said device layer being a double hetero type device layer comprising a pair of hetero barrier layers and an active layer held between said hetero barrier layers, wherein the conduction type of that hetero barrier layer which, of said pair of hetero barrier layers, is provided on the conductive substrate side (hereinafter referred to as the lower hetero barrier layer) is the same as that of said active layer.

**7.** The element array according to claim 6 which comprises a pn laminate structure layer having at least one pn junction comprising a p-type layer having p-type conductivity and an n-type layer having n-type conductivity between said hetero barrier layer and said conductive substrate.

**8.** The element array according to claim 6 which further comprises an oxygen-doped AlGaAs layer between said lower hetero barrier layer and said conductive substrate.

**9.** The element array according to claim 7 which further comprises an oxygen-doped AlGaAs layer between said lower hetero barrier layer and said conductive substrate.

**10.** The element array according to claim 9 wherein said oxygen-doped AlGaAs layer is provided between said conductive substrate and said pn laminate structure layer.

FIG.1

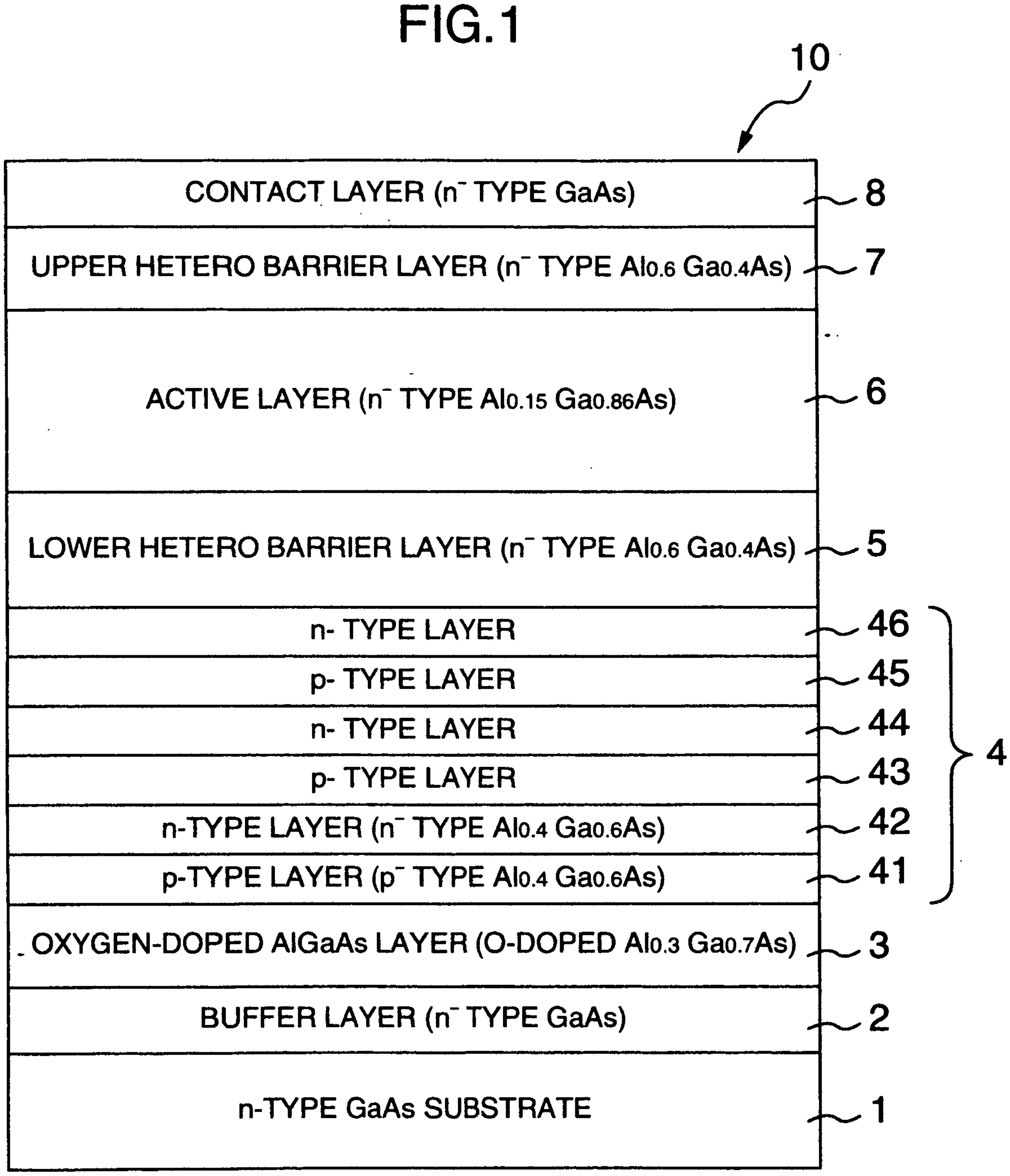
10
CONTACT LAYER (n⁻ TYPE GaAs)
8
UPPER HETERO BARRIER LAYER (n⁻ TYPE Al0.6 Ga0.4As)
7
ACTIVE LAYER (n⁻ TYPE Al0.15 Ga0.86As)
6
LOWER HETERO BARRIER LAYER (n⁻ TYPE Al0.6 Ga0.4As)
5
n- TYPE LAYER
46
p- TYPE LAYER
45
n- TYPE LAYER
44
p- TYPE LAYER
43
n-TYPE LAYER (n⁻ TYPE Al0.4 Ga0.6As)
42
p-TYPE LAYER (p⁻ TYPE Al0.4 Ga0.6As)
41
4
OXYGEN-DOPED AlGaAs LAYER (O-DOPED Al0.3 Ga0.7As)
3
BUFFER LAYER (n⁻ TYPE GaAs)
2
n-TYPE GaAs SUBSTRATE
1

FIG.2